# EUROPÄISCHE PATENTSCHRIFT

(11) **EP 2 530 377 B1**
(45) Veröffentlichungstag und Bekanntmachung des Hinweises auf die Patenterteilung: **09.10.2019**
(21) Anmeldenummer: 12170141.1
(22) Anmeldetag: 31.05.2012
(51) Int. Cl.: H01L 23/367, F21V 29/74, F21V 29/77, F21Y 115/10, F21V 29/00

(54) **Kühlsystem für eine Leuchte**
Cooling system for a light
Système de refroidissement pour lampe

(30) Priorität: 31.05.2011 CH 9292011
(43) Veröffentlichungstag der Anmeldung: 05.12.2012
(73) Patentinhaber: Regent Beleuchtungskörper AG, 4018 Basel (CH)
(72) Erfinder: Wüthrich, Martin, 4417 Ziefen (CH)
(74) Vertreter: Braun, André jr.

(56) Entgegenhaltungen:
- DE-U1-202006 009 553
- US-A1- 2009 009 999
- US-A1- 2009 147 520
- US-A1- 2010 002 453
- US-A1- 2010 014 287
- US-A1- 2010 046 168
- US-A1- 2010 084 116
- US-A1- 2010 103 675
- US-A1- 2011 051 430
- US-A1- 2011 074 265
- US-B1- 6 557 626

## Beschreibung

Die Erfindung betrifft ein Kühlsystem gemäss dem Oberbegriff des unabhängigen Patentanspruchs 1.

### Beschreibung

Aus dem Stand der Technik sind Kühlsysteme, insbesondere Kühlkörper für elektrische Bauelemente wie Prozessoren, Halbleiter-Leistungsschalter, Halbleiter-Leuchtmittel, weitgehend bekannt. Sie dienen dem Abführen von Verlustwärme des Bauelements und dem Übertragen der abgeführten Wärme an die Umgebungsluft. Die natürliche Konvektion kann bspw. mittels Ventilatoren unterstützt werden.

Typischerweise werden Kühlkörper aus wärmeleitendem Leichtmetall, insbesondere Aluminium, hergestellt. Bekannt sind dabei stranggepresste oder - gezogene Profile, welche in entsprechende kurze Abschnitte geteilt werden. Die Profilabschnitte lassen sich nachträglich bearbeiten, bspw. um eine Befestigungsfläche für das elektrische Bauelement bereitzustellen. Einer der Nachteile derartiger Kühlkörper besteht in dem verhältnismässig hohen Gewicht. Ein anderer Nachteil besteht darin, dass Kühlrippen des Profils beim Schneiden in Schwingung geraten, was starken Lärm verursacht. Beim Nachbearbeiten durch Fräsen oder Bohren müssen die Kühlrippen zudem besonders fixiert werden, damit die erforderlichen Bearbeitungstoleranzen eingehalten werden können.

Andere Kühlkörper sind unter dem Begriff "Heatpipe" bekannt, welche mindestens ein in einem Rohr eingeschlossenes Kühlfluid umfassen, wobei am Rohr mehrere Kühlrippen oder-lamellen befestigt sind. Das elektrische Bauteil wird dabei auf eine zusätzliche Kontaktplatte montiert, welche mit dem Rohr verbunden ist. Im Verhältnis zu einem oben beschriebenen und aus einem Profil gebildeten Kühlkörper weisen Heatpipes ein geringeres Gewicht bei vergleichbarem Kühleffekt auf. Nachteilig ist jedoch, dass sie sehr sperrig ausgebildet sind und daher nicht jede gewünschte Bauform, wie sie etwa für eine kompakte Leuchte gefordert wird, realisierbar ist.

Ein Kühlkörper für ein elektrisches Bauelement ist in DE 60203858 T2 offenbart, wobei mehrere dünnwandige Bleche zu einem im Querschnitt ellipsoiden Kühlkörper gestapelt werden, wobei die dünnwandigen Bleche in einem Mittelbereich mittels verschraubten Druckblöcken zusammengepresst sind und wobei in einem Aussenbereich des Kühlkörpers die Bleche voneinander beabstandet sind.

Einer der Nachteile dieses Kühlkörpers besteht darin, dass die Druckblöcke dem Kühlkörper zusätzliches Gewicht verleihen. Ein weiterer Nachteil besteht darin, dass der gezeigte Kühlkörper stets eine ellipsoide Form aufweist.

Die Gebrauchsmusterschrift DE 202010004087 U1 wiederum offenbart eine Leuchte mit einer LED-Lichtquelle, welche auf einer Platine oder einem Sockel angeordnet ist und wobei die Leuchte einen Kühlkörper zur Wärmeabfuhr aufweist, welcher einzelne Lamellen besitzt, die parallel zueinander und um mindestens 45° gegen die optische Achse der Lampe geneigt angeordnet sind.

Einer der Nachteile der Erfindung besteht darin, dass der Kühlkörper ein grosses Volumen beansprucht. Der gewünschte Kamineffekt wird zudem durch die nahe zueinander angeordneten Lamellen eingeschränkt. Die Kühlung muss daher durch Heatpipes unterstützt werden, was sich nachteilig auf die Kosten auswirkt.

Aus Dokument DE 10 2009 008 096 A1 ist ein Kühlkörper für eine Leuchtvorrichtung, bspw. als Retrofitlampe, bekannt, bei welcher mehrere Kühlrippen zueinander durch Kühlrippenzwischenräume beabstandet und an einer vorderen Scheibe sowie einem hinteren Ring befestigt sind. Der Kühlkörper weist bspw. vierzehn dickwandige Lamellen auf, die angeordnet sind, dass eine Luftströmung zwischen den Kühlrippen hindurch quer zur Längsachse erlauben soll.

Einer der Nachteile der Erfindung besteht darin, dass mit dem vorgenannten vergleichbare Kühlkörper aus einem Gussteil gebildet sind, was dazu führt, dass dieses bspw. aus Leichtmetall hergestellten Teils aufwändig nachbearbeitet werden muss. Zudem sind die als Lamellen bezeichneten Stege eher dickwandig ausgebildet.

Das Dokument EP 2233832 A1 offenbart eine Anordnung zur Lichtabgabe mit Leuchtelementen, und einen thermisch mit den Leuchtelementen gekoppelten, und vibrierenden Kühlkörper. Der Kühlkörper kann als Sonnenform-Kühlkörper oder Sonnenstrahlkühlkörper ausgebildet sein. Diesfalls ist die Sonnenform durch einen massiven zylindrischen Kern im Mittelpunkt und mit einem kreisförmig ausgeführten Umfang gebildet, wobei im Mittelpunkt eine Vielzahl von Sonnenstrahlen entspringen. Eine konkrete Ausführungsform eines Sonnenstrahlkühlkörpers ist bspw. als gezogenes Profil realisiert.

Einer der Nachteile eines soeben dargestellten Kühlkörpers besteht wie dargelegt im erheblichen Gewicht sowie in der aufwändigen Bearbeitung. Ein weiterer Nachteil der Anordnung besteht darin, dass der gewichtige Kühlkörper zusätzlich vibriert und zu störender Geräuschbildung führt.

Das Dokument DE 202006009553 U1 zeigt ein LED-Scheinwerfermodul, bei dem für ein Kühlsystem einzelne Kühlflügelscheiben verwendet werden. Die Kühlflügelscheiben sind durch Faltränder verbunden, wobei Vorsprünge an den Faltränder einer Kühlflügelscheibe mit Löchern an den Falträndern einer anderen Kühlflügelscheibe zusammen wirken. Die verbundenen Kühlflügelscheiben werden dann mittels eines weiteren Faltrands mit einem Hauptkörper des Scheinwerfermoduls in Kontakt gebracht. Ein derartiges Kühlsystem ist aufwendig in der Herstellung und umständlich bei der Montage, wodurch die Fertigung des LED-Scheinwerfermoduls kostspielig ist.

Es ist daher Aufgabe der vorliegenden Erfindung, ein Kühlsystem für elektrische Bauelemente vorzuschlagen, welches die Nachteile des Stands der Technik nicht aufweist. Insbesondere soll das Kühlsystem bei geringem Gewicht kühlwirksam, kostengünstig herstellbar und in verschiedenen Bauformen realisierbar sein.

Diese Aufgabe wird durch ein Kühlsystem zum Abführen von Wärme eines elektrischen Bauelements mit den Merkmalen gemäss Anspruch 1 gelöst.

Das Kühlsystem zum Abführen von Wärme eines elektrischen Bauelements, welches mit dem Bauelement in Kontakt steht, weist ein Kühlmodul zum Übertragen der abgeführten Wärme an die Umgebung auf, wobei das Kühlmodul aus einem das elektrische

Bauelement kontaktierende Kontaktelement und mehreren mit dem Kontaktelement in Verbindung stehenden Kühlflügeln zusammengesetzt ist.

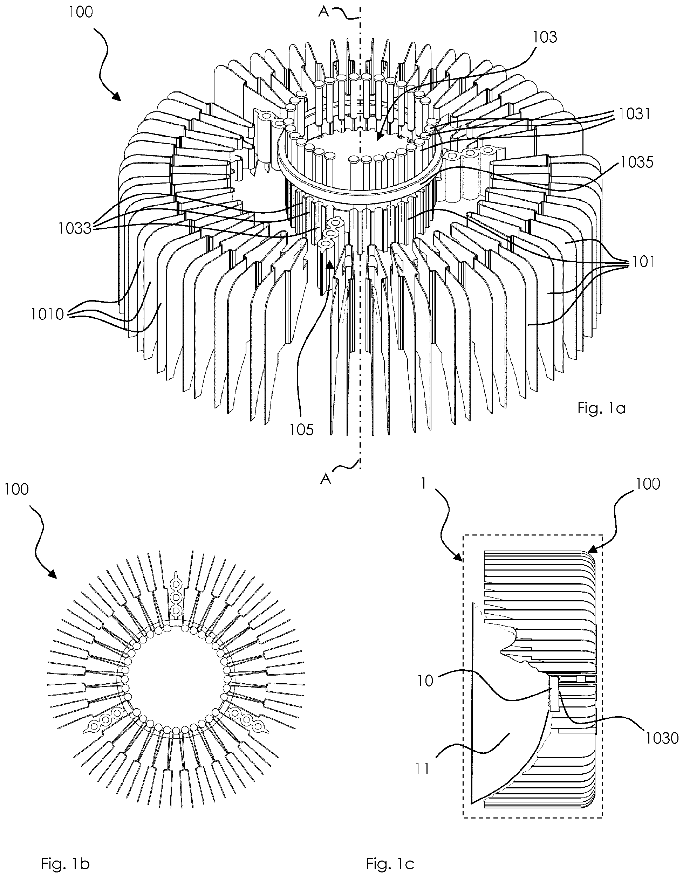

Dabei sind zwei Kühlflügel derart zu einem Kühlflügelpaar geformt, dass die zwei Kühlflügel eine gemeinsame Stirnseite aufweisen, welche ein Anschlussteil bildet, mit dem die Kühlflügel am Kontaktelement befestigbar sind, wie es insbesondere in den Ausführungsbeispielen der Figuren 1, 2 und 5 vorgesehen ist.

Einer der Vorteile der Erfindung besteht darin, dass das Kühlsystem einen äusserst flexiblen Aufbau ermöglicht, welcher insbesondere für den Einsatz für Leuchten geeignet ist, welche insbesondere mit LED ausgebildete Leuchtmittel aufweisen. Die flexible Gestaltung der Kühlflügel erlaubt eine kosteneffiziente Realisierung von Kühlsystemen für unterschiedliche Bauformen und Leistungstypen von Leuchten.

Weitere die Erfindung verbessernde Massnahmen werden nachstehend gemeinsam mit der Beschreibung eines bevorzugten Ausführungsbeispiels der Erfindung anhand der Figuren sowie anhand der abhängigen Ansprüche näher dargestellt.
Fig. 1a zeigt in einer perspektivischen explodierten Ansicht ein Ausführungsbeispiel des erfindungsgemässen Kühlsystems;
Fig. 1b zeigt eine Aufsicht auf das zusammengesetzte Kühlsystem aus Fig. 1a;
Fig. 1c zeigt eine Seitenansicht des zusammengesetzten Kühlsystems aus Fig. 1a für eine Leuchte sowie einen teilweise abgebrochen dargestellten Reflektor der Leuchte mit als Leuchtmittel ausgebildetem elektrischen Bauelement und einem mit unterbrochener Strichlinie schematisch dargestellten Gehäuse der Leuchte;

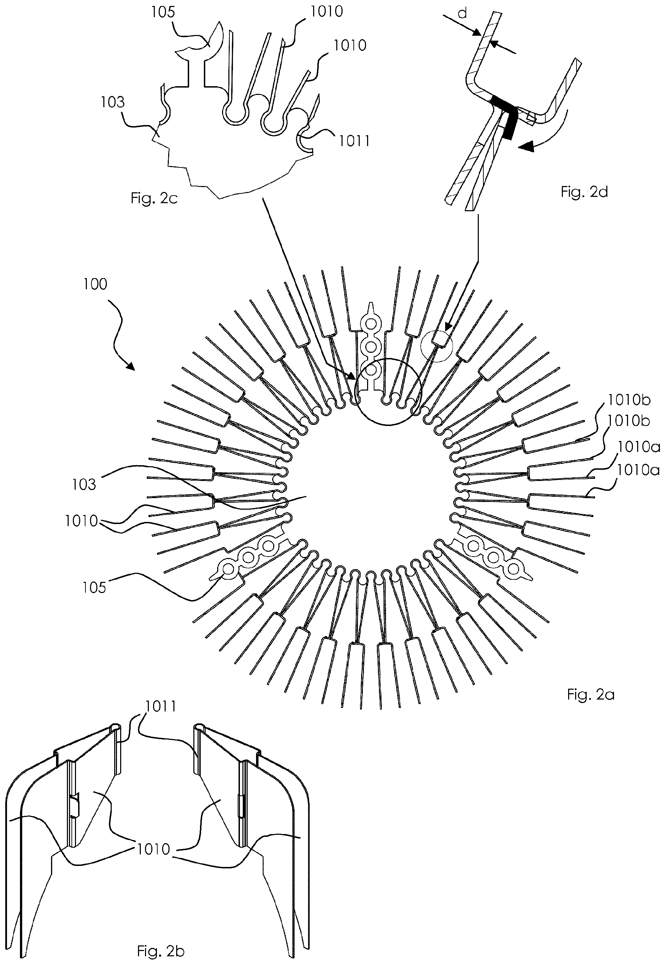

Fig. 2a bis 2d zeigen eine weitere Ausführungsform des erfindungsgemässen Kühlsystems in einer Aufsicht auf das zusammengesetzte Kühlsystem sowie zwei miteinander verbindbare Kühlflügel, welche hier miteinander verhakt sind und zwei entsprechende Detailansichten aus Fig. 2a, zudem sind in Fig. 2b zwei Paare von Kühlflügeln dargestellt;

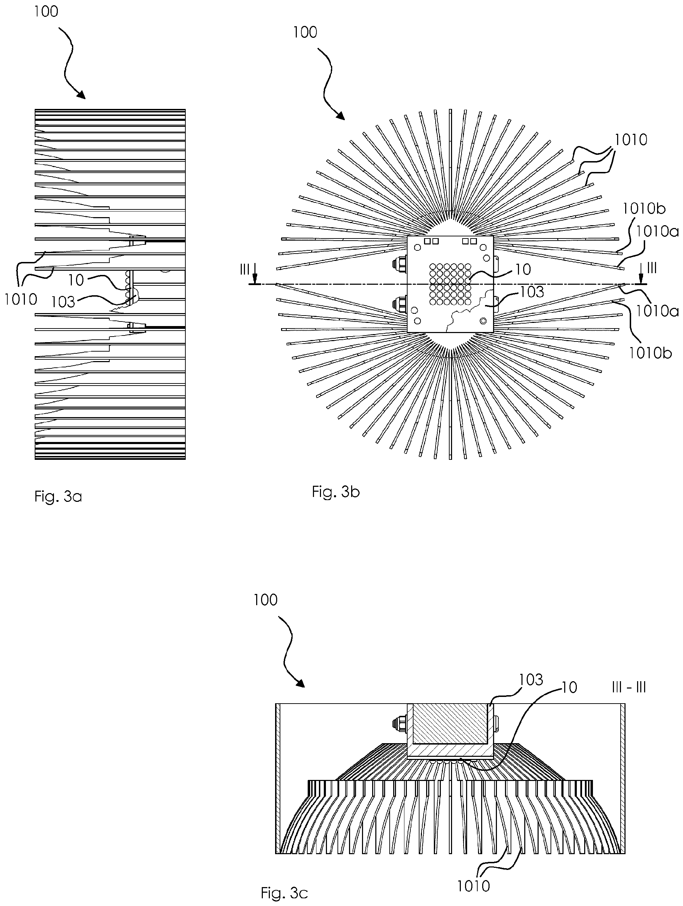

Fig. 3a bis 3c zeigen eine weitere Ausführungsform des erfindungsgemässen Kühlsystems, wobei mehrere Kühlflügel zu einer im Querschnitt kreisrunden Form zusammengesetzt und miteinander verbunden sind, indem Paare von Kühlflügeln zu einem kompakten Stapel zusammengefügt sind, wobei ein Kontaktelement mit mindestens einer Seite des Stapels in Kontakt steht;

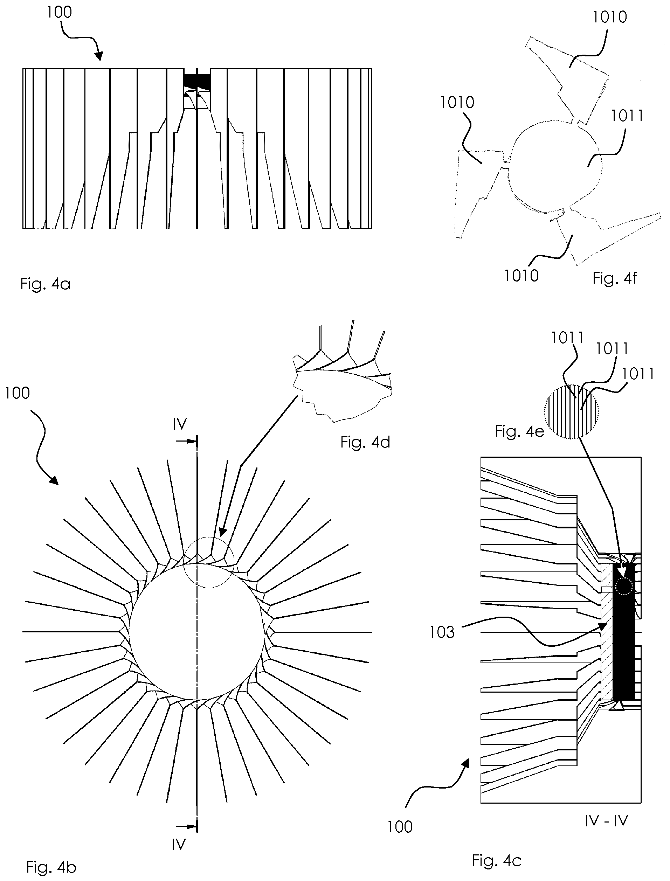

Fig. 4a bis 4f zeigen eine alternative Ausführungsform eines Kühlsystems, wobei mehrere Kühlflügel dadurch miteinander verbunden sind, dass jeder Kühlflügel einen Befestigungsabschnitt aufweist, welcher als orthogonal zur Flügel angeformte Scheibe ausgebildet ist, wobei die mehreren Scheiben gestapelt und miteinander verbunden sind;

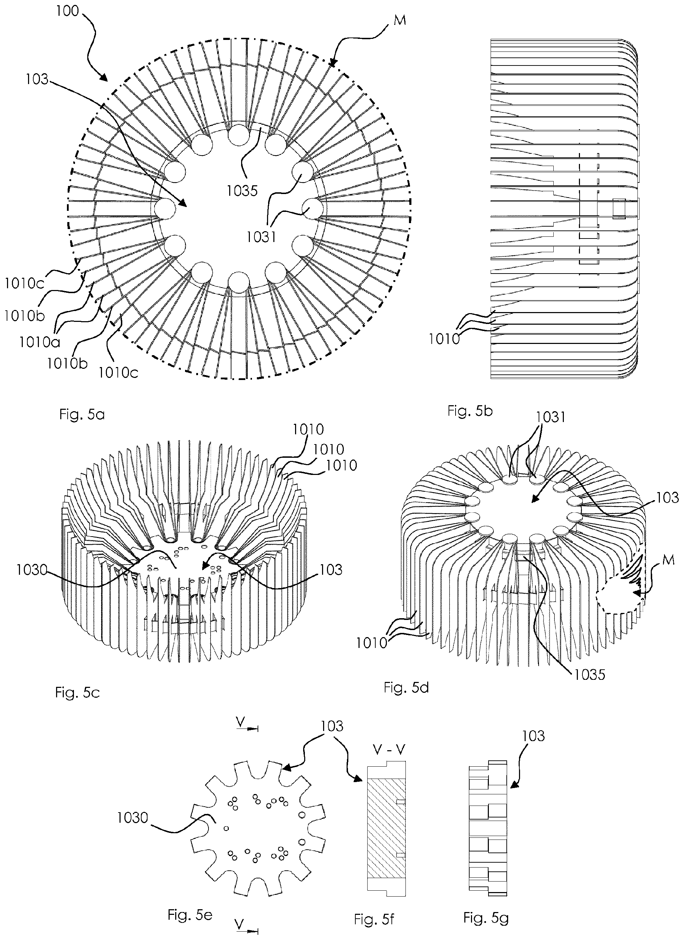

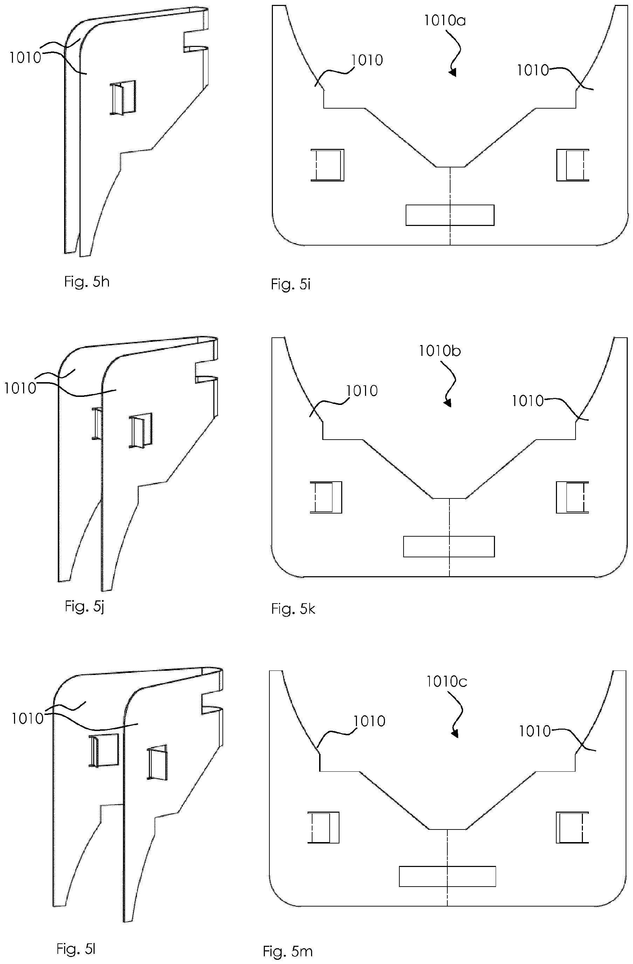

Fig. 5a bis 5g zeigen eine modifizierte Ausführungsform des Kühlsystems gemäss Fig. 1a, wobei jeweils mehrere Paare von Kühlflügeln gestapelt oder verschachtelt und mittels eines Dorns und eines Halte- oder Befestigungsrings am Kontaktelement befestigt sind; Fig. 5h bis 5m zeigen drei Paare von Kühlflügeln in einer perspektivischen Darstellung und in einer jeweils entsprechenden Abwicklung, wobei die drei Paare von Kühlflügeln so ausgebildet sind, dass sie einen Dreierstapel gemäss Fig. 5a bilden.

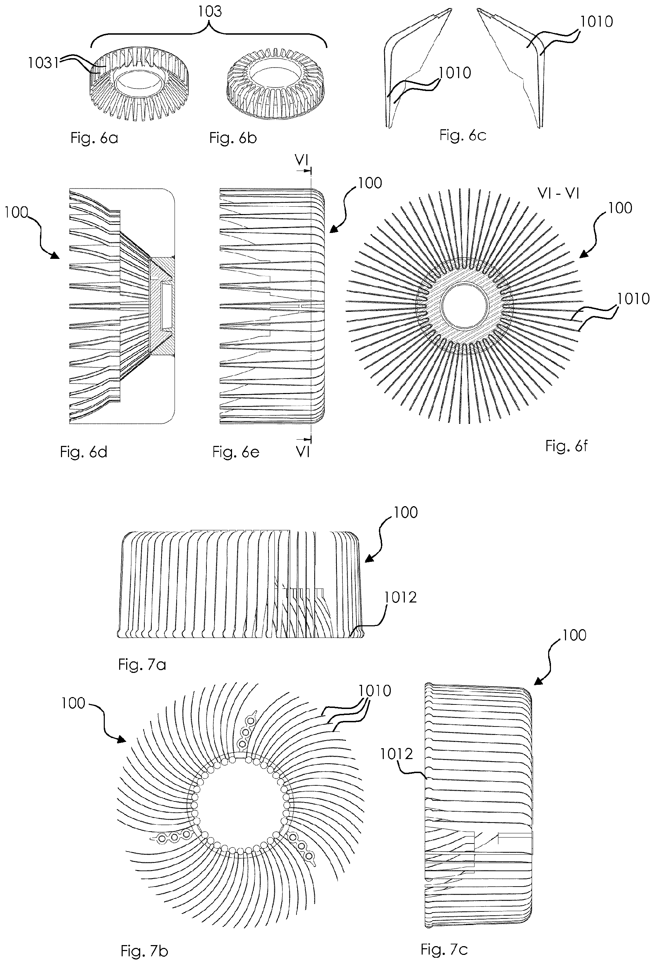

Fig. 6a bis 6f zeigen eine andere Ausführungsform des Kühlsystems, bei welchem der Befestigungsabschnitt eines jeweiligen Paars von Kühlflügeln schräg zur Mittelachse des Kühlsystems am zweiteiligen Kontaktelement anliegt, so dass der thermische Übergang vergrössert wird;
Fig. 7a bis 7c zeigen eine modifizierte Ausführungsform des Kühlsystems gemäss Fig. 1, wobei die Flügelpaare schaufelartig ausgebildet sind;

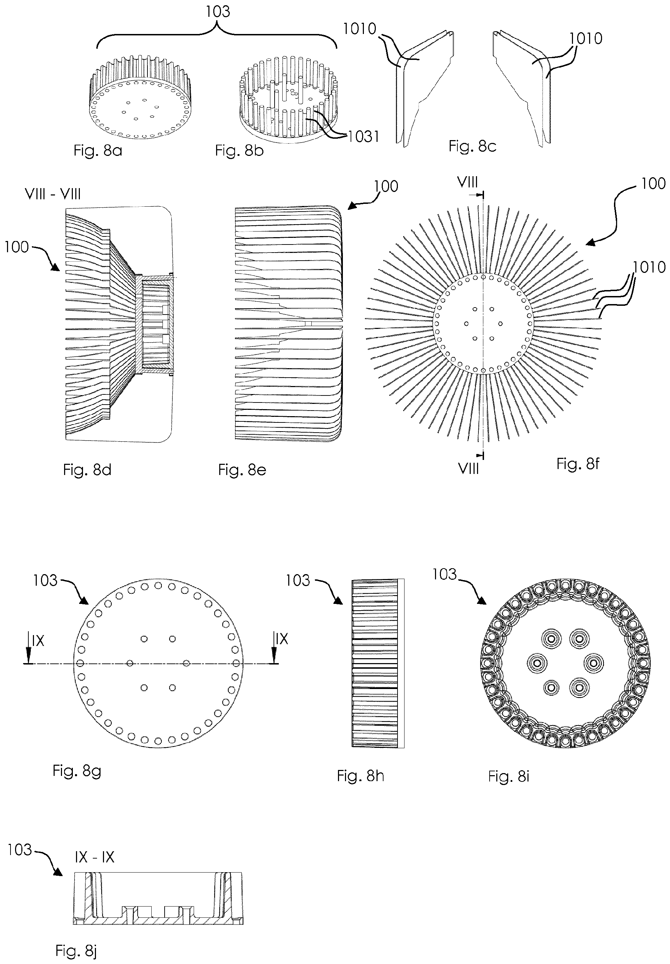

Fig. 8a bis 8k zeigen eine Ausführungsform des Kühlsystems, wonach das Kontaktelement aus zwei Teilen gebildet ist, welche zusammengesteckt werden können, wobei das Kontaktelement in zusammengestecktem Zustand vorzugsweise einen Hohlraum aufweist und wobei die Paare von Kühlflügeln am Kontaktelement mittels Stiften desselben befestigt sind und

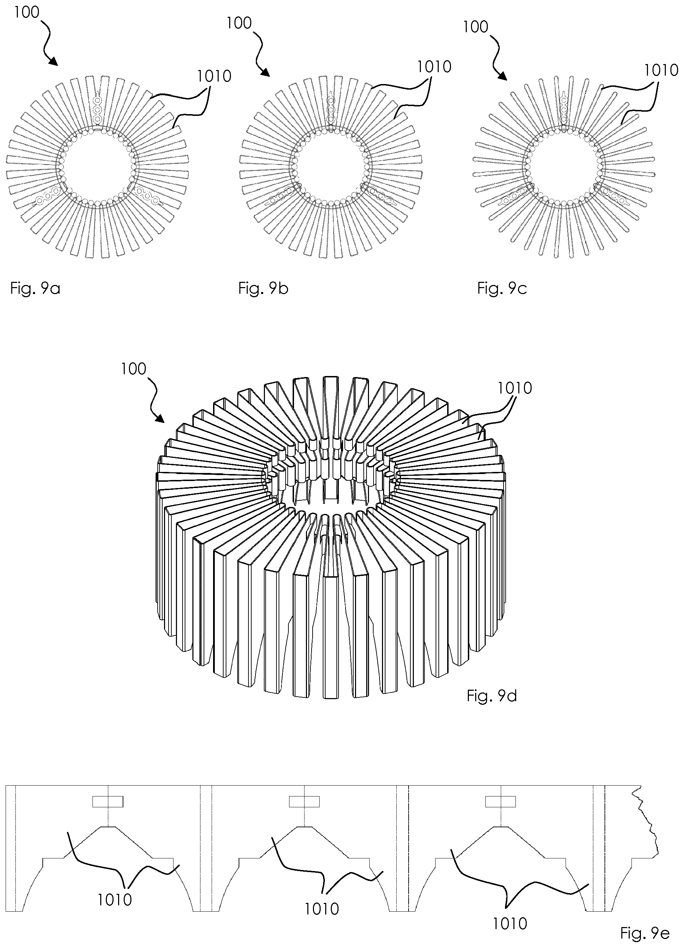

Fig. 9a bis 9e zeigen in jeweils einer Aufsicht weitere Ausführungsformen des Kühlsystems, wobei die einzelnen Kühlflügel aneinander gereiht und aus gefalteten bzw. gebogenen Teilstücken gebildet sind, welche sich um mindestens einen Abschnitt des gesamten Umfangs des Systems erstrecken und es wird eine schematische Ansicht sowie eine abgebrochen dargestellte einstückige Abwicklung von Kühlflügeln gezeigt.

Die Figur 1a illustriert ein bevorzugtes Ausführungsbeispiel des Kühlsystems 100 zum Abführen von Wärme eines elektrischen Bauelements 10. Das Kühlsystem 100 steht dem Bauelement 10 in Kontakt, wobei das Kühlsystem 100 ein Kühlmodul 101 zum Übertragen der abgeführten Wärme an die Umgebung aufweist. Das Kühlmodul 101 ist aus einem das elektrische Bauelement 10 kontaktierende Kontaktelement 103 und mehreren mit dem Kontaktelement 103 in Verbindung stehenden Kühlflügeln 1010 zusammengesetzt. Das Kühlsystem 100 weist zum Verbinden des Kühlmoduls 101 mit einem Gehäuse, einem Reflektor, einem Montagebügel, einem Gebäudeteil o.ä. entsprechend ein oder mehrere Befestigungsteile 105 auf. Diese sind vorzugsweise mit dem Kontaktelement 103 verbunden. Ein Befestigungsteil 105 kann auch am Kontaktelement 103 angeformt sein.

Das Kontaktelement 103 ist bspw. aus geeignetem wärmeleitendem Leichtmetall, bspw. Aluminium gebildet. Es kann auch aus Kupfer, Neusilber oder dergleichen sowie aus Kombinationen davon gebildet sein. Das Kontaktelement 103 kann auch aus einem Kunststoff bspw. im Spritzgiessverfahren geformt sein, wobei ein Kunststoff mit besonders guten Wärmeleiteigenschaften verwendet wird. Dies wird durch thermisch leitfähige Kunststoffe erzielt, welche mit metallischen Elementen versetzt sind. Die Formgebung ist dadurch äusserst vielfältig, was ein besonderer Vorteil der Erfindung ist.

Das Kontaktelement 103 ist vorzugsweise im Wesentlichen in zylindrischer Form ausgebildet, wobei der Mantel des Kontaktelements 103 Rillen, Nuten und/oder Ausnehmungen aufweist. Diese erstrecken sich mindestens stellenweise entlang des Mantels. Zur Montage von Kühlflügeln 1010 am Kontaktelement 103 ist mindestens ein Ring 1035, Draht oder dergleichen vorhanden, welcher mit Stiften 1031, Dornen oder dergleichen zusammenwirkt. Der mindestens eine Kühlflügel 1010 wird dadurch am Kontaktelement montiert, indem der Ring 1035 über das Kontaktelement 103 geschoben wird; anschliessend wird mindestens ein Kühlflügel 1010 an das Kontaktelement angelegt, worauf der Dorn 1031 durch einen Abschnitt des Anschlussteils 1011 des Kühlflügels 1010 und zwischen dem Ring 1035 hindurch geschoben bzw. gepresst wird. Im eingesetzten Zustand liegt der Dorn oder Stift 1031 an einem oberen und einem unteren Abschnitt des Anschlussteils 1011 einerseits und teilweise an der Innenseite des Rings an. Der Kühlflügel 1010 ist dadurch mit dem Kontaktelement fest verbunden. Die Wärme kann somit vom Bauelement über die Kontaktfläche 1030 (Figur 1c) des Kontaktelements 103 direkt an den bzw. die Kühlflügel 1010 übertragen und von diesen an die Umgebung abgeleitet werden.

Die Figur 1b zeigt eine Aufsicht auf das zusammengesetzte Kühlsystem aus Figur 1, wobei ersichtlich ist, dass jeder Kühlflügel mit einem Dorn am Kontaktelement kontaktiert bzw. thermisch gekoppelt ist. Jeder Dorn wird durch einen Ring am Kontaktelement gehalten. Der Ring kann auch Bestandteil des Kontaktelements sein, bspw. indem er an diesem angeformt ist. Aus der Aufsicht sind auch die Befestigungsteile zum Befestigen des Kühlsystems an einem Gestell, Gebäudeteil, Gehäuse o.ä. ersichtlich.

Ein Kühlflügel 1010 kann in allen Ausführungsformen der Erfindung aus Blech, bspw. aus Aluminium, oder aus wärmeleitendem Kunststoff oder aus wärmeleitendem Papier hergestellt sein. Vorzugsweise bilden zwei Kühlflügel jeweils ein Kühlflügelpaar. Diese sind als Abwicklung in einem bekannten Verfahren, bspw. durch Laserschneiden, Stanzen, Scheren, Tiefziehen und/oder Biegen herstellbar.

Ein Dorn oder Stift 1031 kann aus Metall, Kunststoff o.ä. oder aus Materialverbindungen hergestellt sein.

Ein Ring 1035 ist vorzugsweise, aber nicht zwingenderweise aus wärmeleitendem Material hergestellt. Er muss derart ausgebildet sein, dass jeder Dorn ausreichend gegen das Kontaktelement 103 gedrückt wird, so dass der bzw. jeder Dorn sich aus dessen eingesetzter Position nicht selbstständig lösen kann. Damit der Ring zwischen Dorn und Kühlflügel eingesetzt werden kann, weist jeder Kühlflügel eine entsprechende Ausnehmung auf.

Die Figur 1c zeigt eine teilweise abgebrochene Seitenansicht des zusammengesetzten Kühlsystems aus der Figur 1, wobei hier zusätzlich ein Reflektor 11 und eine als Leuchtmittels ausgebildetes elektrisches Bauelement 10 dargestellt sind. Die gestrichelte Linie zeigt vereinfacht dargestellt den Umriss einer Leuchte 1 bzw. eines Gehäuses der Leuchte.

Die Figuren 2a bis 2d illustrieren eine weitere Ausführungsform des Kühlsystems 100 in einer Aufsicht auf das zusammengesetzte Kühlsystem sowie zwei miteinander zu einem Kühlflügelpaar verbundene Kühlflügel 1010. In der Detailansicht aus Figur 2c ist ein das Kontaktelement 103 aus Figur 2a abgebrochen dargestellt. Zudem sind abgebrochen dargestellte Kühlflügel 1010 gezeigt. In dieser Ausführungsform weist das Kontaktelement breit ausgebildete Zapfen auf. Zwischen jeweils zwei Zapfen wird eine Nut gebildet, die derart ausgebildet ist, dass die Nut einen Innenraum aufweist, welcher sich nach aussen, also zum Mantel des Kontaktelements hin verengt. In der gezeigten Aufsicht ist die Nut im Querschnitt bspw. tropfenförmig ausgebildet.

Jeweils zwei Kühlflügel 1010 bilden ein Kühlflügelpaar, wie dies in Figur 2b gezeigt ist, wo zwei Kühlflügelpaare abgebildet sind. Ein solches Kühlflügelpaar kann aus einem Materialstück, bspw. aus Blech oder wärmeleitendem Kunststoff oder wärmeleitendem Papier gebildet sein. Durch Stanzen, Schneiden, Scheren, Biegen und/oder Falten kann die dargestellte Form erzielt werden. Das Anschlussteils 1011 ist mindestens stellenweise deformierbar ausgebildet, so dass durch Zusammendrücken des Kühlflügelpaars das Anschlussteil im Querschnitt mindestens vorübergehend schmaler wird, um in die oben beschriebene tropfenartige Nut des Kontaktelements 103 eingeführt zu werden. Ist das Anschlussteil 1011 vollständig eingeführt, wird der Anpressdruck auf das Kühlflügelpaar reduziert, so dass im Querschnitt das deformierbare Anschlussteil aufgeweitet wird und in der Nut Einsitz nimmt. Das Anschlussteil ist im eingesetzten Zustand thermisch mit dem Kontaktelement 103 gekoppelt und zur Wärmeübertragung verbunden.

Die Figur 2d zeigt einen ebenfalls in Figur 2b ersichtlichen Verbindungsmechanismus zwischen zwei Kühlflügeln 1010 von benachbarten Kühlflügelpaaren, wobei die Paare mittels des Verbindungsmechanismus miteinander mechanisch verbindbar sind. Hier ist beispielhaft ein Haken am einen Kühlflügel angeformt, welcher in eine Öffnung an einem benachbarten Kühlflügel eingreift. Die Kühlflügelpaare lassen sich damit verketten, was dem Kühlsystem insgesamt mehr Stabilität verleiht.

Zum Herstellen eines Kühlsystems der beschriebenen Art ist vorstellbar, dass in einer Ausführungsform desselben vorerst ein zahnradartig ausgebildetes Kontaktelement 103 hergestellt wird, wobei vorzugsweise aus jeweils einem Blechstück geformte Paare von Kühlflügeln 1010 stirnseitig im Bereich des jeweiligen Flügelansatzes in eine der Nuten des Kontaktelements eingesetzt werden. Es ist vorstellbar, dass Kühlflügelpaare aus federndem Blech geformt sind, derart, dass sie die gemeinsame Stirnseite durch Zusammendrücken der beiden Flügel verengt wird, und nach dem Einführen in die entsprechende Ausnehmung oder Nut am Kontaktelement der Druck auf die Flügel entfernt wird, so dass sie sich aufspreizen, wodurch das Paar von Kühlflügeln dauerhaft in der Nut Einsitz nimmt und befestigt ist.

Die Figuren 3a bis 3c illustrieren eine andere Ausführungsform des erfindungsgemässen Kühlsystems 100, wobei mehrere Kühlflügel zu einer im Querschnitt kreisrunden Form zusammengesetzt und miteinander verbunden sind, indem Paare 1010a,1010b,... von Kühlflügeln 1010 zu einem kompakten Stapel zusammengefügt sind, wobei ein Kontaktelement 103 mit mindestens einer Seite des Stapels in Kontakt steht.

Die Figuren 4a bis 4f zeigen eine alternative Ausführungsform eines Kühlsystems, wobei mehrere Kühlflügel 1010 dadurch miteinander verbunden sind, dass jeder Kühlflügel 1010 einen Befestigungsabschnitt 1011 aufweist, weicher als orthogonal angeformte Scheibe ausgebildet ist, wobei die mehreren Scheiben gestapelt und miteinander verbunden sind. Figur 4f zeigt eine beispielhafte nicht massstäblich dargestellte Abwicklung, bevor die Flügel zum Befestigungsabschnitt 1011 ungefähr rechtwinklig abgebogen werden. Je nach Dimensionierung des von Kühlflügel und Befestigungsabschnitt 1011 können ein, zwei oder mehr Kühlflügel 1010 am Befestigungsabschnitt angeformt sein. Mehrere solcher gebogener Abwicklungen werden übereinander gestapelt, bis die nötige Zahl der Kühlflügel vorhanden ist. In Figur 4e ist in einer Detailansicht aus Figur 4c ersichtlich, wie die Befestigungsabschnitte 1011 übereinander oder nebeneinander gestapelt sind. Figur 4d zeigt in einer Detailansicht, wie der Biegebereich ausgebildet sein kann.

Die Figuren 5a zeigt eine weitere Ausführungsform eines erfindungsgemässen Kühlsystems 100 in einer schematischen Aufsicht, wobei mehrere, vorliegend jeweils drei Paare von Kühlflügeln 1010 über- bzw. ineinander gelegt und mit dem Kontaktelement 103 mittels eines Dorns oder Stifts 1031 und einem Abschnitt eines Halterings 1035 verbunden sind. Das Bezugszeichen M illustriert eine gedachte Mantelfläche des Kühlsystems, wobei ersichtlich ist, dass der Mantel eine vorzugsweise kreisrunde Form aufweist. Es ist jedoch vorstellbar, die Flügel derart zu dimensionieren, dass andere Mantelflächen erzielbar sind, so dass die Form in Aufsicht bspw. polygonal ist. Mit Bezugszeichen 1010a,1010b,1010c sind Paare von Kühlflügeln 1010 bezeichnet, welche in einander geschachtelt oder gestapelt und am Kontaktelement 103 befestigt sind.

Die Figur 5b zeigt eine Seitenansicht des Kühlsystems 100, wobei die Flügel durch an ihnen angeformte Distanzteile aufweisen. Dadurch kann der Abstand zwischen Kühlflügeln bestimmt werden.

Die Figur 5c zeigt eine perspektivische Ansicht der Ausführungsform des Kühlsystems 100 auf die Kontaktfläche 1030. Es sind hier verschiedene Löcher oder Bohrungen dargestellt, welche zur Aufnahme von Befestigungsmitteln, etwa Schrauben, Nieten oder dergleichen ausgebildet sind, um das nicht dargestellte elektrische Bauelement zu befestigen. Die Ansicht zeigt eine wannenartige Anordnung der Kühlflügel, so dass bspw. ein Reflektor einer Leuchte in dieser Wanne Einsitz nehmen kann.

Die Figur 5d zeigt eine andere Ansicht auf besagtes Kühlsystem, wobei die gezeigte Fläche des Kontaktelements 103 als Rückseite bezeichnet werden kann. Das Bezugszeichen M bezeichnet einen abgebrochen dargestellten und gedachten Mantel, welcher durch die fächerartig aufgereihten Kühlflügel 1010 gebildet wird.

Die Figuren 5e, 5f und 5g zeigen eine Aufsicht, einen Schnitt entlang der Linie V-V dieser Aufsicht sowie eine Seitenansicht des Kontaktelements 103. In der Aufsicht hat das Kontaktelement ungefähr die Form eines Zahnrads. Die entsprechenden Ausnehmungen zwischen den Zähnen sind ausgebildet, um Kühlflügel aufzunehmen und diese mittels Dorn und Haltering am Kontaktelement zu befestigen. Es ist vorstellbar, dass der Haltering auch am Kontaktelement angeformt sein kann, bzw. dass Haltering und Kontaktelement aus einem Stück gebildet sind.

Die Figuren 5h bis 5m illustrieren drei Paare 1010a,1010b,1010c von Kühlflügeln 1010 in einer perspektivischen Darstellung und in einer jeweils entsprechenden Abwicklung, wobei die drei Paare von Kühlflügeln so ausgebildet sind, dass sie einen Dreierstapel gemäss Figur 5a bilden.

Die Figuren 6a bis 6f illustrieren eine andere Ausführungsform des Kühlsystems 100, bei welchem der Befestigungsabschnitt 1011 eines jeweiligen Paars von Kühlflügeln 1010 schräg zur Mittelachse des Kühlsystems 100 am zweiteiligen Kontaktelement 103 anliegt, so dass der thermische Übergang vergrössert wird. Wie aus Figur 6c ersichtlich, sind die Kühlflügel eines Kühlflügelpaars nicht zwingend parallel zueinander angeordnet, so dass zwischen den Flügeln ein spitzer Winkel gebildet ist. Die Figur 6a illustriert ein erstes Teil des Kontaktelements 103, welches beim Montieren als Montagehilfe genutzt werden kann, wobei jeweils ein Kühlflügelpaar über einen der abstehenden, dreieckig ausgebildeten Dorne gestülpt werden kann. Sind alle Dorne mit Kühlflügelpaaren besetzt, so wird das Teil des Kontaktelements 103 in Figur 6b auf die vormontierten Kühlflügel aufgesetzt. Figur 6d zeigt in einem Halbschnitt des Kühlsystems 100, wie die beiden Teile in zusammengesetztem Zustand die Kühlflügel einspannen. Die beiden Teile können verschraubt, genietet, geklebt, verpresst oder sonst auf bekannte weise thermisch vorteilhaft miteinander verbunden werden. Figur 6f illustriert einen Schnitt entlang der Linie VI-VI.

Die Figuren 7a bis 7c illustrieren eine modifizierte Ausführungsform des Kühlsystems gemäss Figur 1a, wobei die Paare von Kühlflügeln 1010 schaufelartig ausgebildet sind. Vorzugsweise jeder Flügel kann ein Rast- oder Schnappelement 1012 aufweisen, welches an der aussenliegenden Schnittkante angeformt ist. Dadurch, dass die Flügel gebogen, schaufelartig ausgebildet sind, ist das Kühlsystem 100 in der Lage, bei der Montage in einem Gehäuse oder einem Gebäudeteil gewisse Montagetoleranzen auszugleichen. Die Flügel sind mindestens teilweise elastisch oder dehnbar. Durch Zusammendrücken am Umfang des Kühlsystems 100 können die Flügel, wird der Aussendurchmesser des Kühlsystems vorübergehend verkleinert. Nach dem Loslassen federn die Flügel in ihre Ausgangsposition zurück. Die Rastelemente 1012 können dabei in eine Nut oder einen Vorsprung einschnappen, so dass dadurch das System 100 bspw. am Gehäuse befestigt wird.

Die Figuren 8a bis 8k zeigen eine Ausführungsform des Kühlsystems, wonach das Kontaktelement aus zwei Teilen gebildet ist, welche zusammengesteckt werden können, wobei das Kontaktelement 103 in zusammengestecktem Zustand vorzugsweise einen Hohlraum aufweist und wobei die Paare von Kühlflügeln 1010 am Kontaktelement 103 mittels Stiften desselben befestigt sind.

Die Figuren 9a bis 9e zeigen in jeweils einer Aufsicht weitere Ausführungsformen des Kühlsystems 100, wobei die einzelnen Kühlflügel 1010 aneinander gereiht und aus gefalteten bzw. gebogenen Teilstücken gebildet sind, welche sich um mindestens einen Abschnitt des gesamten Umfangs des Systems 100 erstrecken. Figur 9e zeigt eine schematische Ansicht sowie eine abgebrochen dargestellte mögliche Realisierung einer einstückigen Abwicklung von Kühlflügeln.

Bevorzugt wird ein Kühlsystem der beschriebenen Art verwendet für eine Leuchte mit einem als Halbleiter-Element ausgebildeten Leuchtmittel, bspw. einem LED-Modul. Dieses LED-Modul mit mindestens einer LED wird mit dem Kontaktelement des Kühlsystems mechanisch und thermisch kontaktiert, bspw. durch Verkleben oder durch Befestigungsmittel, wie Schrauben oder Nieten.

Es ist vorstellbar, dass das Kühlsystem 100 ein oder mehrere Befestigungsteile 105 aufweist, welche am Kontaktteil 103 angeformt sind. Ein Reflektor 11 der Leuchte 1 kann bspw. an bzw. mit den Kühlflügeln 1010 befestigt werden. Er kann alternativ oder zusätzlich an einem oder mehreren Befestigungsteilen 105 befestigt oder montiert sein.

Die Befestigungsteile 105 können auch dazu dienen, das Kühlsystem an einem Gehäuse zu befestigen.

### Bezugszeichenlegende

- 1: Leuchte
- 10: elektrisches Bauelement, Leuchtmittel
- 11: Reflektor
- 100: Kühlsystem
- 101: Kühlmodul
- 1010: Kühlflügel
- 1010a,1010b,...: Kühlflügelpaar
- 1011: Anschlussteil, Flügelstapelteil, Befestigungsabschnitt
- 1012: Schnappteil, Befestigungsteil, Einrastteil
- 103: Kontaktelement
- 1030: Kontaktfläche
- 1031: Haltedorn, Dorn, Stift
- 1033: Haltering, Draht
- 1035: Haltenut, Ausnehmung
- 105: Befestigungsteil

- A: Achse, Mittelachse
- d: Materialstärke
- M: Mantel

## Patentansprüche

1. Kühlsystem (100) zum Abführen von Wärme eines elektrischen Bauelements (10), welches mit dem Bauelement (10) in Kontakt steht, wobei das Kühlsystem (100) ein Kühlmodul (101) zum Übertragen der abgeführten Wärme an die Umgebung aufweist, und das Kühlmodul (101) aus einem das elektrische Bauelement (10) kontaktierenden Kontaktelement (103) und mehreren mit dem Kontaktelement (103) in Verbindung stehenden Kühlflügeln (1010) zusammengesetzt ist, **dadurch gekennzeichnet, dass** zwei Kühlflügel (1010) derart zu einem Kühlflügelpaar (1010a; 1010b) geformt sind, dass die zwei Kühlflügel (1010) eine gemeinsame Stirnseite aufweisen, welche ein Anschlussteil (1011) bildet, mit dem die Kühlflügel (1010) am Kontaktelement (103) befestigbar sind.

2. Kühlsystem (100) gemäss Anspruch 1, **dadurch gekennzeichnet, dass** Befestigungsmittel in Form von mindestens einem Ring (1035) oder Draht und Stiften (1031) vorgesehen sind, wobei zur Befestigung eines Kühlflügelpaares der Ring (1035) über das Kontaktelement (103) schiebbar ist und der Stift (1031) derart durch einen Abschnitt des Anschlussteils (1011) und zwischen dem Ring (1035) hindurch schiebbar ist, dass der Stift (1031) an einem oberen und einem unteren Abschnitt des Anschlussteils (1011) einerseits und teilweise an einer Innenseite des Rings anliegt.

3. Kühlsystem (100) gemäss Anspruch 1, **dadurch gekennzeichnet, dass** am Kontaktelement (103) Nuten derart ausgebildet sind, dass sie einen Innenraum aufweisen, welcher sich nach aussen zu einem Mantel des Kontaktelements hin verengt, so dass das Anschlussteil (1011) eines Kühlflügelpaars in einer Nut Einsitz nehmen kann.

4. Kühlsystem (100) gemäss Anspruch 3, **dadurch gekennzeichnet, dass** das Anschlussteil (1011) eines Kühlflügelpaar deformierbar ausgebildet ist.

5. Kühlsystem (100) gemäss Anspruch 3 oder 4, **dadurch gekennzeichnet, dass** zwischen zwei Kühlflügeln (1010) von benachbarten Kühlflügelpaaren ein Verbindungsmechanismus vorgesehen ist, mit dem die Kühlflügelpaare miteinander mechanisch verbindbar sind.

6. Kühlsystem (100) gemäss einem der vorhergehenden Ansprüche, **dadurch gekennzeichnet, dass** mehrere, vorzugsweise drei Kühlflügelpaare ineinander geschachtelt sind.

7. Kühlsystem (100) gemäss Anspruch 6, **dadurch gekennzeichnet, dass** die Kühlflügel (1010) Distanzteile für einen Abstand zwischen Kühlflügeln aufweisen.

8. Kühlsystem (100) gemäss Anspruch 1, **dadurch gekennzeichnet, dass** die Kühlflügel (1010) mit dem Kontaktelement (103) wiederentfernbar verbunden sind.

9. Kühlsystem (100) gemäss einem der vorgenannten Ansprüche, **dadurch gekennzeichnet, dass** das Kontaktelement (103) eine ebene Kontaktfläche (1030) umfasst, welche mit dem Bauelement (10) in Kontakt steht,und die dünnwandigen Kühlflügel (1010) im Wesentlichen orthogonal zur Kontaktfläche angeordnet sind.

10. Kühlsystem (100) gemäss einem der vorgenannten Ansprüche, **dadurch gekennzeichnet, dass** das Kontaktelement (103) des Kühlsystems (100) mit dem elektrischen Bauelement (10) mechanisch und thermisch kontaktiert ist.

11. Kühlsystem (100) gemäss einem der vorgenannten Ansprüche, **dadurch gekennzeichnet, dass** die Kühlflügel (1010) einen im Wesentlichen zylindrischen Mantel (M) des Kühlsystems (100) definieren.

12. Kühlsystem (100) gemäss einem der vorgenannten Ansprüche, **dadurch gekennzeichnet, dass** jeder Kühlflügel (1010) eine gleichmässige Materialstärke (d) aufweist.

13. Kühlsystem (100) gemäss einem der vorgenannten Ansprüche, **dadurch gekennzeichnet, dass** das Kontaktelement (103) eine Kontaktfläche (1030) aufweist, welche im Wesentlichen orthogonal zur Wandung (d) des bzw. jedes Kühlflügels (1010) angeordnet ist.

14. Kühlsystem (100) gemäss einem der vorgenannten Ansprüche, **dadurch gekennzeichnet, dass** das Kühlsystem (100) mindestens ein mit dem Kontaktelement (103) verbundenes Befestigungsteil (105) umfasst, um insbesondere das Kühlsystem an einem Gehäuse oder Gebäudeteil zu befestigen.

15. Kühlsystem (100) gemäss einem der vorgenannten Ansprüche, **dadurch gekennzeichnet, dass** das Kontaktelement (103) aus einem oder aus mehreren miteinander verbindbaren Teilen besteht.

16. Leuchte (1) mit einem als Leuchtmittel ausgebildeten elektronischen Bauteil (10) **gekennzeichnet durch** ein Kühlsystem (100) gemäss einem der vorgenannten Ansprüche.

## Claims

1. Cooling system (100) for dissipating heat of an electrical component (10), which system is in contact with the component (10),
the cooling system (100) having a cooling module (101) for transferring the dissipated heat to the surrounding region, and the cooling module (101) being composed of a contact element (103) which contacts the electrical component (10) and a plurality of cooling vanes (1010) which are in contact with the contact element (103),
**characterized in that** two cooling vanes (1010) form a pair of cooling vanes (1010a; 1010b) such that the two cooling vanes (1010) have a common end face which forms a connection part (1011), by means of which the cooling vanes (1010) can be fastened to the contact element (103).

2. Cooling system (100) according to claim 1, **characterized in that**
fastening means in the form of at least one ring (1035) or wire and pins (1031) are provided, it being possible, in order to attach a pair of cooling vanes, to move the ring (1035) over the contact element (103), and to move the pin (1031) through a portion of the connection part (1011) and between the ring (1035), such that the pin (1031) rests against an upper and a lower portion of the connection part (1011) and partially rests against an inner face of the ring.

3. Cooling system (100) according to claim 1, **characterized in that**
grooves are formed on the contact element (103) such that they have an interior which narrows in the outward direction towards a casing of the contact element, such that the connection part (1011) of a pair of cooling vanes can be placed in a groove.

4. Cooling system (100) according to claim 3, **characterized in that**
the connection part (1011) of a pair of cooling vanes is deformable.

5. Cooling system (100) according to either claim 3 or claim 4, **characterized in that**
a connection mechanism is provided between two cooling vanes (1010) of adjacent pairs of cooling vanes, by means of which mechanism the pairs of cooling vanes are mechanically connectable to one another.

6. Cooling system (100) according to any of the preceding claims, **characterized in that**
a plurality of, preferably three, pairs of cooling vanes are nested inside one another.

7. Cooling system (100) according to claim 6, **characterized in that**
the cooling vanes (1010) have spacer parts for providing a distance between cooling vanes.

8. Cooling system (100) according to claim 1, **characterized in that**
the cooling vanes (1010) are removably connected to the contact element (103).

9. Cooling system (100) according to any of the preceding claims, **characterized in that**
the contact element (103) comprises a planar contact surface (1030) which is in contact with the component (10), and the thin-walled cooling vanes (1010) are arranged substantially orthogonally to the contact surface.

10. Cooling system (100) according to any of the preceding claims, **characterized in that**
the contact element (103) of the cooling system (100) is in mechanical and thermal contact with the electrical component (10).

11. Cooling system (100) according to any of the preceding claims, **characterized in that**
the cooling vanes (1010) define a substantially cylindrical casing (M) of the cooling system (100).

12. Cooling system (100) according to any of the preceding claims, **characterized in that**
each cooling vane (1010) has a uniform material thickness (d).

13. Cooling system (100) according to any of the preceding claims, **characterized in that**
the contact element (103) has a contact surface (1030) which is arranged substantially orthogonally to the wall (d) of the or each cooling vane (1010).

14. Cooling system (100) according to any of the preceding claims, **characterized in that**
the cooling system (100) comprises at least one fastening part (105) which is connected to the contact element (103) in order to in particular fasten the cooling system to a housing or part of a building.

15. Cooling system (100) according to any of the preceding claims, **characterized in that**
the contact element (103) consists of one or more interconnectable parts.

16. Light (1) comprising an electronic component (10) which is designed as a lamp, **characterized by** a cooling system (100) according to any of the preceding claims.

## Revendications

1. Système de refroidissement (100) destiné à dissiper la chaleur d'un composant électrique (10), lequel système de refroidissement est en contact avec le composant (10), le système de refroidissement (100) comportant un module de refroidissement (101) destiné à transférer la chaleur dissipée dans l'environnement, et le module de refroidissement (101) étant composé d'un élément de contact (103) en contact avec le composant électrique (10) et de plusieurs ailettes de refroidissement (1010) reliées à l'élément de contact (103), **caractérisé en ce que** deux ailettes de refroidissement (1010) sont façonnées en un couple d'ailettes de refroidissement (1010a ; 1010b), de telle manière que les deux ailettes de refroidissement (1010) présentent un côté frontal commun formant une partie de liaison (1011), au moyen de laquelle les ailettes de refroidissement (1010) peuvent être fixées à l'élément de contact (103).

2. Système de refroidissement (100) selon la revendication 1, **caractérisé en ce que** des moyens de fixation sous la forme d'au moins un anneau (1035) ou d'un fil et de broches (1031) sont prévus, l'anneau (1035) pouvant coulisser par-dessus l'élément de contact (103) pour la fixation d'une paire d'ailettes de refroidissement, et la broche (1031) pouvant coulisser à travers une section de la partie de liaison (1011) et entre l'anneau (1035) de telle manière que la broche (1031) repose sur une section supérieure et inférieure de la partie de liaison (1011), d'une part, et partiellement sur le côté intérieur de l'anneau.

3. Système de refroidissement (100) selon la revendication 1, **caractérisé en ce que** des rainures sont réalisées au niveau de l'élément de contact (103), de telle manière qu'elles comportent un espace intérieur qui se rétrécit vers l'extérieur pour former une enveloppe de l'élément de contact, de telle manière que la partie de liaison (1011) d'une paire d'ailettes de refroidissement puisse reposer dans une rainure.

4. Système de refroidissement (100) selon la revendication 3, **caractérisé en ce que** la partie de liaison (1011) d'une paire d'ailettes de refroidissement est conçue de façon déformable.

5. Système de refroidissement (100) selon la revendication 3 ou 4, **caractérisé en ce qu'**un mécanisme de liaison permettant de relier mécaniquement les paires d'ailettes de refroidissement est prévu entre deux ailettes de refroidissement (1010) de paires d'ailettes de refroidissement adjacentes.

6. Système de refroidissement (100) selon l'une des revendications précédentes, **caractérisé en ce que** plusieurs, de préférence trois paires d'ailettes de refroidissement sont emboîtées les unes dans les autres.

7. Système de refroidissement (100) selon la revendication 6, **caractérisé en ce que** les ailettes de refroidissement (1010) comportent des entretoises pour l'écartement entre les ailettes de refroidissement.

8. Système de refroidissement (100) selon la revendication 1, **caractérisé en ce que** les ailettes de refroidissement (1010) sont reliées de manière amovible à l'élément de contact (103).

9. Système de refroidissement (100) selon l'une des revendications précédentes, **caractérisé en ce que** l'élément de contact (103) comprend une surface de contact (1030) plane qui est en contact avec le composant (10), et **en ce que** les ailettes de refroidissement (1010) à parois minces sont disposées de manière sensiblement orthogonale à la surface de contact.

10. Système de refroidissement (100) selon l'une des revendications précédentes, **caractérisé en ce que** l'élément de contact (103) du système de refroidissement (100) est en contact mécanique et thermique avec le composant électrique (10).

11. Système de refroidissement (100) selon l'une des revendications précédentes, **caractérisé en ce que** les ailettes de refroidissement (1010) définissent une enveloppe (M) sensiblement cylindrique du système de refroidissement (100).

12. Système de refroidissement (100) selon l'une des revendications précédentes, **caractérisé en ce que** chaque ailette de refroidissement (1010) a une épaisseur de matériau (d) uniforme.

13. Système de refroidissement (100) selon l'une des revendications précédentes, **caractérisé en ce que** l'élément de contact (103) comporte une surface de contact (1030) disposée de manière sensiblement orthogonale à la paroi (d) de l'ailette de refroidissement ou de chaque ailette de refroidissement (1010).

14. Système de refroidissement (100) selon l'une des revendications précédentes, **caractérisé en ce que** le système de refroidissement (100) comprend au moins une partie de fixation (105) reliée à l'élément de contact (103), notamment pour fixer le système de refroidissement à un boîtier ou à une partie de construction.

15. Système de refroidissement (100) selon l'une des revendications précédentes, **caractérisé en ce que** l'élément de contact (103) est constitué d'une ou de plusieurs parties pouvant être reliées.

16. Luminaire (1) comportant un composant électronique (10) réalisé sous la forme d'un moyen d'éclairage, **caractérisé par** un système de refroidissement (100) selon l'une des revendications précédentes.
